Europäisches Patentamt

(19) European Patent Office

Office européen des brevets

(11) Veröffentlichungsnummer: **0 186 040**
**B1**

(12) **EUROPÄISCHE PATENTSCHRIFT**

(45) Veröffentlichungstag der Patentschrifft:
21.03.90

(51) Int. Cl.⁵: **G 11 C 29/00**

(21) Anmeldenummer: 85115739.6

(22) Anmeldetag: 10.12.85

(54) Integrierter Halbleiterspeicher.

(30) Priorität: 28.12.84 DE 3447762

(43) Veröffentlichungstag der Anmeldung:
02.07.86 Patentblatt 86/27

(45) Bekanntmachung des Hinweises auf die Patenterteilung:
21.03.90 Patentblatt 90/12

(84) Bennante Vertragsstaaten:
AT DE FR GB IT NL

(56) Entgegenhaltungen:
EP-A-0 046 215
EP-A-0 127 015
EP-A-0 143 624
JP-A-51 147 924
US-A-4 495 603

ISSCC'81, 18. Februar 1981, Seiten 84,85, IEEE, New York, US; S. SHEFFIELD EATON et al.: "A 100ns 64K dynamic RAM using redundancy techniques"

ELEKTRONIK, Nr. 15, 30. Juli 1982, Seiten 27-30, München, DE; P. MATTOS et al.: "'Nibble-mode' beschleunigt Speicherzugriff"

PATENTS ABSTRACTS OF JAPAN, Band 6, Nr. 62 (P-111) 940 , 21. April 1982; & JP - A - 57 3298 (NIPPON DENKI K.K.) 08-01-1982

(73) Patentinhaber: Siemens Aktiengesellschaft
Wittelsbacherplatz 2
D-8000 München 2 (DE)

(72) Erfinder: Hoffmann, Kurt, Dr. Prof.
Nelkenweg 20
D-8028 Taufkirchen (DE)

EP 0 186 040 B1

**Beschreibung**

Die Erfindung betrifft einen integrierten Halbleiterspeicher nach dem Oberbegriff des Patentanspruches 1.

Halbleiterspeicher der vorgenannten Art sind z. B. aus IEEE International Solid-State Circuits Conference 1981, Seiten 84 bis 85 und aus Elektronik, Nr. 15, 30.7.1982, Seiten 27 bis 30 bekannt. Bei diesen gattungsgemäßen Halbleiterspeichern ist es bekannt, einen gesamten Speicherbereich, der dem Anwender gegenüber 1-Bit breite Datenschnittstellen für Datenein- und -ausgabe hat, in n einander gleiche Zellenfelder aufzuteilen. Dazu ist es üblich, jedem Zellenfeld speicherintern eine eigene Datenleitung zuzuordnen, die alle über eine erste Datenweiche mit einem Dateneingangsanschluß verbunden sind. Im Betrieb erfolgt die Auswahl, welche der n Datenleitungen auf den Dateneingangsanschluß durchgeschaltet werden soll, über den bzw. eine entsprechende Anzahl von höchstwertigen Adreßeingang (-eingängen). Analog dazu sind die n Datenleitungen mit einem Datenausgangsanschluß über eine zweite Datenweiche verbunden.

Der Wert von n ist geradzahlig. Er ist weiterhin gleich der Anzahl der gewünschten Zellenfelder und hängt davon ab, ob an Adreßeingängen, über die der Halbleiterspeicher ja bekanntlich adressiert wird, einfache Adreßsignale, d.h. nur sogenannte X-Adressen bzw. Y-Adressen angelegt werden, oder aber solche Adreßsignale, die innerhalb einer Taktperiode des Halbleiterspeichers nacheinander sowohl eine X-Adresse als auch eine Y-Adresse enthalten (Adreßmultiplexing). In diesem Fall kann n nur eine durch 4 teilbare Zahl sein.

Des weiteren sind auch Halbleiterspeicher bekannt, die mehr als 1-Bit breite Datenschnittstellen für Datenein- und -ausgabe haben. Typische Organisationsformen dazu sind Datenschnittstellen in einer Breite von m = 4, 8 und 9 Bit. Solcher Art gestaltete Halbleiterspeicher enthalten aufgrund der fortschreitenden Integrationsmöglichkeiten immer mehr Speicherzellen. Die Zunahme an Speicherzellen je Halbleiterspeicher bedingt jedoch sowohl bei dessen Hersteller als auch beim Kunden, der ja in aller Regel eine sogenannte "incoming inspection" durchführt, einen erhöhten zeitlichen, personellen und finanziellen Aufwand zur Prüfung (Testen) von Halbleiterspeichern. Aufgrund der speziellen, notwendigen Ausgestaltung von Prüfmustern für das Testen steigt die zum Testen notwendige Zeit sogar exponentiell mit der Zunahme an Speicherzellen an. Aus diesem Grunde ist es wünschenswert, die Prüfzeit deutlich verkürzen zu können, ohne die erwendeten Prüfmuster in ihrer Effizienz beschneiden zu müssen. Frühere Versuche mit integrierten Schaltkreisen, bei denen mehrere Halbleiterchips bzw. -bausteine parallel von einem Prüfautomaten getestet wurden, ergaben zwar eine hervorragende Prüfzeitverkürzung, der notwendige mechanische Aufwand dazu (Prüfspitzen auf Scheibenebene, Meßfassungen mit Kabeln, auf Bausteinebene) war jedoch sehr groß. Außerdem mußten vorhandene Prüfprogramme auf komplizierte Art und Weise angepaßt werden.

Aufgabe der vorliegenden Erfindung ist es deshalb, einen integrierten Halbleiterspeicher zu schaffen, der es ermöglicht, die Prüfzeit ohne Verlust an Effizienz der eingesetzten Prüfmuster deutlich zu verkürzen.

Diese Aufgabe wird erfindungsgemäß gelöst durch die kennzeichnenden Merkmale des Patentanspruches 1. Grundgedanke der Erfindung ist dabei, einen Halbleiterspeicher so auszugestalten, daß er zwar einerseits wie üblich (Normalfall) betrieben werden kann, es jedoch andererseits (Testfall) möglich ist, Teilbereiche des Halbleiterspeichers speicherintern parallel zu schalten und sowohl ausgelesene Daten als auch ev. aufgetretene Fehler meßtechnisch an einen Speicheranschluß (-pad, -pin) erfassen zu können.

Vorteilhafte Weiterbildungen und Ausprägungen der Erfindung sind in Unteransprüchen gekennzeichnet. Die Erfindung ist u.a. anwendbar sowohl auf DRAM's und SRAM's als auch auf EPROM's und EEPROM's.

Im folgenden wird die Erfindung anhand von Figuren näher beschrieben. Es zeigen:

Fig. 1   eine erste Ausführungsform der Erfindung,

Fig. 2   eine spezielle Ausgestaltung einer Auswerteschaltung AS,

Fig. 3   eine zweite Ausführungsform der Erfindung,

Fig. 4   eine dritte Ausführungsform der Erfindung,

Fig. 5   die erste Ausführungsform der Erfindung, angewandt auf einen Speicher mit acht Zellenfeldern,

Fig. 6   die erste Ausführungsform der Erfindung, angewandt auf einen Speicher mit Datenschnittstellen in einer Breite von 2 Bit,

Fig. 7   ein Zeitdiagramm, das aufzeigt, wie ein vorzeitiges Zurücksetzen einer Fehlerinformation verhindert wird.

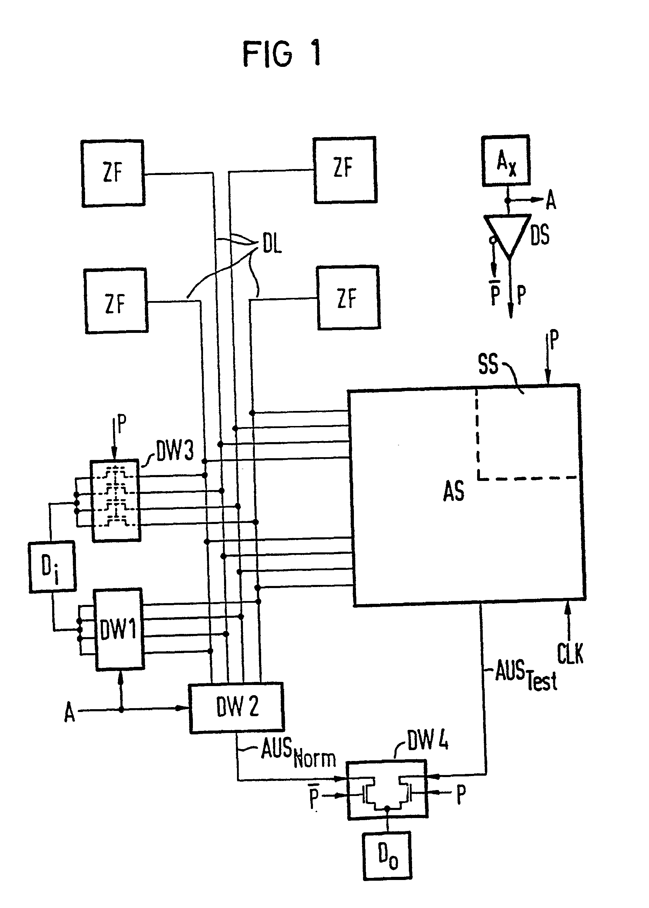

Gemäß Fig. 1 enthält ein erfindungsgemäßer Halbleiterspeicher mit m = 1 Dateneingangsanschluß $D_i$ und m = 1 Datenausgangsanschluß $D_0$ n = 4 einander gleiche Zellenfelder ZF (z. B. bei einem "Megabit"-Speicher: Gesamtanzahl der Speicherzellen: 1024 k · 1 Bit = 1 M · 1 Bit, dies ergibt bei n = 4 vier Zellenfelder ZF à 256 k · 1 Bit). An jedes Zellenfeld ZF ist eine von n Datenleitungen DL angeschlossen. Diese dienen dem Einschreiben von Informationen in die Zellenfelder ZF bzw. zu deren Auslesen. In bekannter Weise sind diese n = 4 Datenleitungen DL über eine erste Datenweiche DW1 mit dem Dateneingangsanschluß $D_i$ verbunden. Zum Einschreiben von Information in den Speicher wird durch Ansteuerung der ersten Datenweiche DW1 mittels einer bestimmten Adresseninformation, nämlich einem Adressierungssignal A, das am höchstwertigen ($A_x$) von vorhandenen Adreßanschlüssen liegt, im Normalbetrieb die am Dateneingangschluß $D_i$ anliegende Information auf eine der n = 4 vorhandenen Datenleitungen DL geschaltet, von wo aus sie in das entsprechende Zellenfeld ZF eingeschrieben wird. Entsprechend dazu sind die Datenleitungen DL über eine zweite Datenweiche DW2 mit dem Datenausgangsanschluß $D_o$ verbunden. Diese wird adressierungsmäßig genauso angesteuert wie die erste Datenweiche DW1. Sie schaltet eine der n Datenleitungen DL auf den Datenausgangsanschluß $D_o$. Diese bisher beschriebenen Teile eines erfindungsgemäßen Halbleiterspeichers sind für sich allein bereits bekannt. Sie finden beispielsweise Anwendung in Halbleiterspeichern, die die sogenannten "Nibble-Mode"-Betriebsweise erlauben.

Der erfindungsgemäße Halbleiterspeicher enthält nun in vorteilhafter Art und Weise, parallel zur ersten Datenweiche DW1 eine dritte Datenweiche DW3, mittels derer im Testbetrieb am Dateneingangsanschluß $D_i$ anliegende Informationen gleichzeitig auf alle n = 4 Datenleitungen DL übergeben werden. Die dritte Datenweiche DW3 kann beispielsweise n = 4 parallel geschaltete Transistoren enthalten, deren eine Seite ihrer Durchlaßstrecken gemeinsam an den Dateneingangsanschluß $D_i$ angeschlossen sind und deren andere Seiten an je eine Datenleitung DL angeschlossen sind. Gatemäßig angesteuert werden die Transistoren der dritten Datenweiche DW3 durch ein Steuersignal P, dessen Erzeugung später beschrieben wird. Schreibt man über diese dritte Datenweiche DW3 Informationen in die Zellenfelder ZF, so enthalten diese Zellenfelder ZF untereinander dieselben Informationen.

Betrachtet man nun im Testbetrieb jedes der Zellenfelder ZF als einen eigenen Speicher (Prüfling), so kann man die (Test-)Informationen, die adressierungsmäßig auf ein Zellenfeld ZF abgestimmt sein müssen, gleichzeitig parallel in alle Zellenfelder ZF einschreiben.

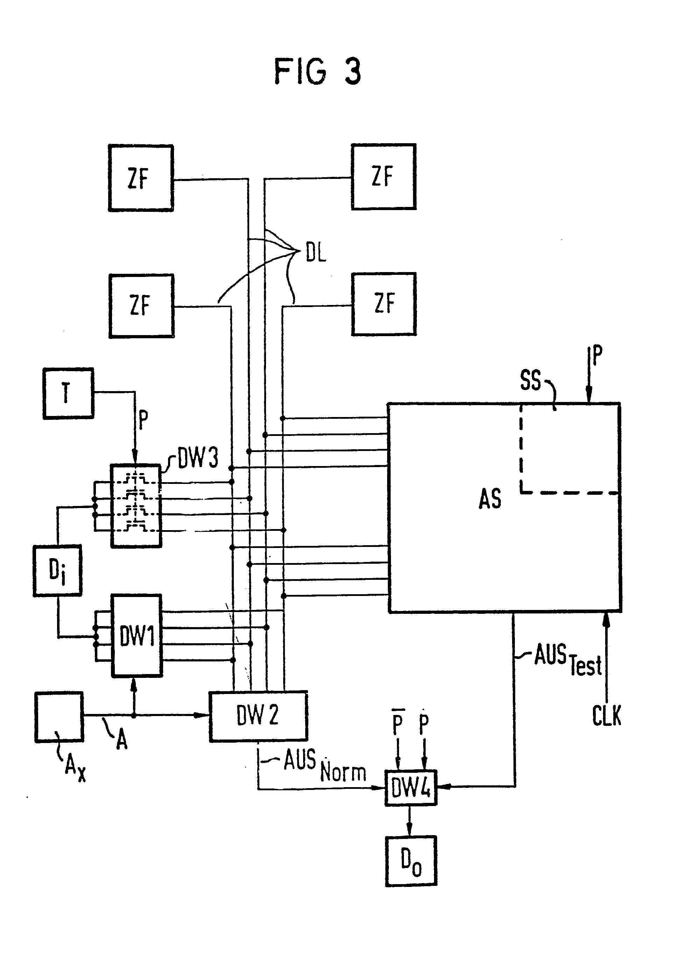

Das Steuersignal P, das die dritte Datenweiche DW3 aktiviert, kann auf verschiedene Arten gewonnen werden. In einer Ausführungsform gemäß Fig. 3 wird im Testfall an einen weiteren Anschluß T ein Testsignal in Form eines konstanten Potentiales (z. B. log. '1') angelegt. Im Normalbetrieb wird entweder ein konstantes Potential z. B. mit dem Wert log. '0' angelegt oder aber der Anschluß T bleibt unbeschaltet. Das so erzeugte Steuersignal P, das direkt am Anschluß T abgegriffen werden kann, steuert dann u.a. die Gates der dritten Datenweiche DW3 an, so daß deren Transistoren durchschalten. Diese Lösung hat einerseits den Vorteil, einen Potentialwert wählen zu können, der sonst auch zur Ansteuerung des Halbleiterspeichers verwendet wird (z. B. "TTL-Pegel"). Andererseits wird aber für den Anschluß T ein zusätzlicher Anschluß benötigt, der unter Umständen aufgrund von Gehäuseabmessungen des Halbleiterspeichers nicht verfügbar ist.

In einer anderen Ausführungsform, dargestellt in Fig. 1, wird ein Anschluß mitbenutzt, der ansonsten für den Normalbetrieb benützt wird. Als geeignetster Anschluß bietet sich ein Anschluß an, der der Ansteuerung des Halbleiterspeichers mit Adreßinformationen dient, insbesondere der für die höchstwertige X- bzw. Y- bzw. X/Y-Information (beim heute üblichen Adreßmultiplexverfahren). Im Normalbetrieb wird an einen solchen Anschluß bei heute üblichen Halbleiterspeichern beispielsweise ein (höchstwertiges) Adreßsignal A mit einem '0'-Pegel von 0 Volt und einem '1'-Pegel von 5 Volt angelegt. Bei der Ausführungsform des erfindungsgemäßen Halbleiterspeichers nach Fig. 1 wird dieser Anschluß allgemein mit $A_x$ bezeichnet. An diesem liegt im Normalfall die höchstwertige X/Y-Adreßinformation. Für den Testbetrieb wird ein Potential angelegt, das z. B. deutlich über dem '1'-Pegel des üblichen, am Adreßanschluß $A_x$ anliegenden Adreßsignales A liegt, beispielsweise 10 V. Eine nachgeschaltete Diskriminatorschaltung DS erkennt dieses angelegte Potential und erzeugt das halbleiterspeicherinterne Steuersignal P. Diskriminatorschaltungen DS sind als solche an sich bekannt, beispielsweise in Form von Schwellwertschaltern. Bekannte Schwellwertschalter sind z. B. der DE-OS-3 030 852 und der DE-OS-3 318 564 entnehmbar. Es sind jedoch auch andere Ausgestaltungen nach dem Stande der Technik denkbar.

Des weiteren enthält ein erfindungsgemäßer Halbleiterspeicher noch m einander gleiche Auswerteschaltungen AS (m = Breite der Datenschnittstellen für Datenein- und -ausgabe).

Aufgabe jeder dieser Auswerteschaltungen AS ist es, beim Auslesen aus dem Halbleiterspeicher die auf den der jeweiligen Auswerteschaltung AS zugeordneten n Datenleitungen DL anliegende Informationen zu übernehmen und sie in dem Falle, wo alle diese Informationen untereinander gleich sind (was aufgrund von zuvor stattgefundenem parallelem Abspeichern in die Zellenfelder ZF ja dem "Gut-Fall" entspricht), über einen Ausgang $AUS_{Test}$ an den Datenausgangsanschluß $D_o$ weiterzuleiten und in dem Falle, in dem diese Daten einander nicht gleich sind (Fehlerfall), an ihrem Ausgang $AUS_{Test}$ ein Fehlersignal zu aktivieren und dieses solange am Datenausgangsanschluß $D_o$ anliegen zu lassen, bis es z. B. ein an den Datenausgangsanschluß $D_o$ angeschlossener Prüfautomat als aktiviertes Fehlersignal erkennen kann. Aufgrund der verwendeten binären Logik besitzt dieses aktivierte Fehlersignal im Fehlerfall z. B. den Wert log. '0' (eine umgekehrte Definition ist selbstverständlich denkbar).

Wird nun während des Testens des Halbleiterspeichers aufgrund eines an diesen angelegten Prüfmusters eine log. '1' am Datenausgangsanschluß $D_o$ als ausgelesene Information erwartet, so sind folgende drei Fälle möglich:

a) alle Zellenfelder ZF funktionieren richtig: jede der n = 4 Datenleitungen DL erhält von einer gerade angesteuerten Speicherzelle ihres zugeordneten Zellenfeldes ZF eine log. '1', die die Auswerteschaltung AS an den Datenausgangsanschluß $D_O$ weiterreicht und die vom Testautomaten als "gut" erkannt wird.

b) alle Zellenfelder ZF sind an den gerade angesteuerten Speicherzellen defekt (äußerst unwahrscheinlich als Einzelfehler, im allgemeinen fast Totalausfall des Halbleiterspeichers): über die Datenleitungen DL werden nur logische '0'-Signale ausgelesen, die die Auswerteschaltung AS zwar nicht als Fehler erkennt und deshalb als log. '0' an den Datenausgangsanschluß $D_O$ weiterreicht, der Prüfautomat jedoch erkennt den Fehler.

c) 1 bis n-1 Zellenfeld(er) ZF enthält (enthalten) eine fehlerhafte, adressierte Speicherzelle: die Auswerteschaltung AS erkennt dies, aktiviert an ihrem Ausgang das Fehlersignal und reicht dieses beispielsweise als log. '0' an den Datenausgangsanschluß $D_O$ weiter. Der Prüfautomat erkennt den Fehler.

Wird am Datenausgangsanschluß $D_O$ dagegen eine log. '0' erwartet, so ist der Ablauf in den Fällen a) und b) analog wie bei einer log. '1' als erwarteter Information, jedoch im Falle c) wird der Fehler zwar innerhalb der Auswerteschaltung AS als solcher erkannt, und das Fehlersignal am Ausgang $AUS_{Test}$ der Auswerteschaltung AS wird aktiviert. Dieses jedoch unterscheidet sich in seinem Pegel ("0") nicht von der erwarteten Information (ebenfalls "0"). In diesem Falle jedoch bleibt aufgrund der vorteilhaften Ausgestaltung der Auswerteschaltung AS, die nachfolgend noch beschrieben wird, das Fehlersignal solange aktiviert, bis eine log. "1" ausgelesen wird, die jedoch aufgrund des vorher aufgetretenen Fehlers nicht an den Datenausgangsanschluß $D_O$ weitergereicht wird. Anstatt dessen bleibt das Fehlersignal (log. '0') aktiviert, d.h. der Prüfautomat bemerkt den Fehler. Anschließend deaktiviert die Auswerteschaltung AS das Fehlersignal über eine eingebaute Setschaltung SS wieder. Für übliche Serienprüfungen beim Hersteller (auf Scheibenebene, mit und ohne redundante Speicherzellen, auf Bausteinebene) sowie für incoming inspection beim Kunden ist das völlig ausreichend; Prüfen zu Analysezwecken oder ähnliches ist wegen der bei Parallelprüfung innerhalb eines Halbleiterspeichers anfallenden Adressierungsungenauigkeit (welches Zellenfeld ZF ist defekt?) nicht möglich.

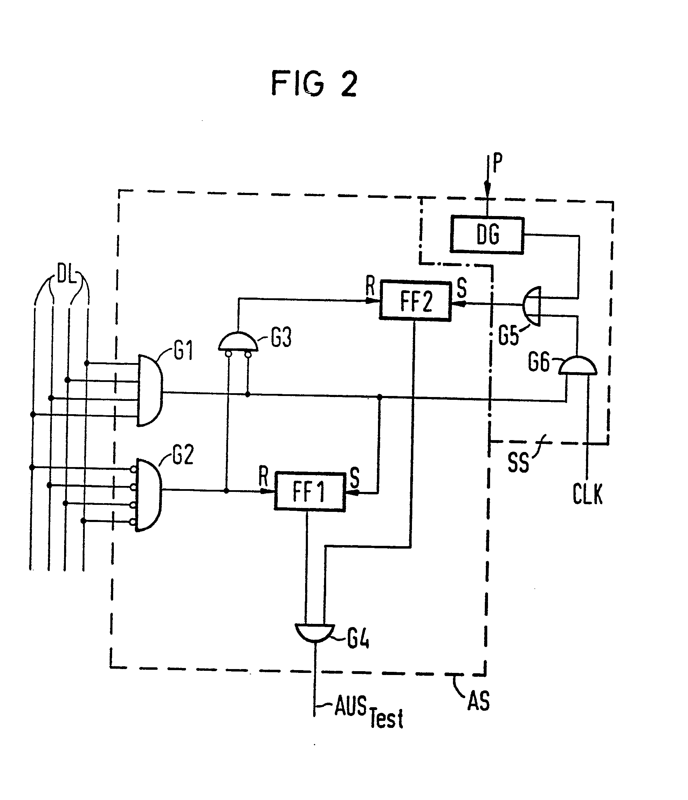

Eine mögliche, vorteilhafte Ausgestaltung der Auswahlschaltung AS ist in Fig. 2 gezeigt. Sie wird nachfolgend erläutert.

Ein erstes UND-Gatter G1 hat n = 4 Eingänge. Diese sind mit je einer der n = 4 Datenleitungen DL verbunden. Ein zweites UND-Gatter G2 ist dem ersten UND-Gatter G1 eingangsmäßig parallel geschaltet. Seine ebenfalls n = 4 Eingänge sind jedoch negiert, so daß das zweite UND-Gatter G2 wie eine NOR-Funktion wirkt. Das erste UND-Gatter G1 schaltet an seinem Ausgang nur dann auf log. "1", wenn alle Datenleitungen DL auf log. "1" liegen. Analoges gilt für den Ausgang des zweiten UND-Gatters G2 (Ausgang nur dann log. "1", wenn alle Datenleitungen DL auf log. "0").

Die Auswerteschaltung AS enthält des weiteren eine erste Kippschaltung FF1, beispielsweise in Form eines RS-Flip-Flops mit Set- und Reseteingang S, R, sowie einem Ausgang. Der Seteingang S ist mit dem Ausgang des ersten UND-Gatters G1 verbunden und setzt den Ausgang der ersten Kippschaltung FF1 auf log. "1", wenn an allen Eingängen des ersten UND-Gatters G1 eine log. "1" anliegt. Analog dazu ist der Reseteingang R mit dem Ausgang des zweiten UND-Gatters G2 verbunden. Der Ausgang wird also gesetzt, wenn auf allen n = 4 Datenleitungen DL eine logische "1" anliegt und rückgesetzt, wenn ensprechend an allen Datenleitungen DL eine log. "0" anliegt. Im Fehlerfall liegt keine dieser Konditionen vor, die erste Kippschaltung FF1 ändert ihren Ausgang nicht.

Parallel zum Anschluß an die beiden Eingänge der ersten Kippschaltung FF1 sind die Ausgänge der beiden UND-Gatter G1, G2 in negierter Form an ein drittes UND-Gatter G3 angeschlossen. Dieses wirkt also ebenfalls als NOR-Funktion. Der Ausgang des dritten UND-Gatters G3 ist nur dann auf log. "1", wenn ein Fehler vorliegt, d.h. wenn nicht alle n = 4 Datenleitungen DL denselben logischen Pegel ("0" oder "1") besitzen. In diesem Fehlerfall setzt er als Reseteingang R eine zweite Kippschaltung FF2 zurück, die im Aufbau gleich der ersten Kippschaltung FF1 sein kann. Die zweite Kippschaltung FF2 weist auch einen als Seteingang S ausgebildeten weiteren Eingang auf. Dieser wird von einer Setschaltung SS gesteuert.

Die zweite Kippschaltung FF2 besitzt einen Ausgang, der vom Seteingang S auf log. "1" und vom Reseteingang R auf log. "0" gesetzt wird. Da der Reseteingang R immer im Fehlerfall aktiviert wird, kann man auch folgendes sagen: Der Ausgang der zweiten Kippschaltung FF2 wird im Fehlerfall zurückgesetzt (= auf log. "0"), ansonsten entweder gesetzt (log. "1") oder er bleibt unverändert.

Die Ausgänge der beiden Kippstufen FF1, FF2 bilden zwei Eingänge eines vierten UND-Gatters G4, deren Ausgang mit dem ($AUS_{Test}$) der Auswerteschaltung AS identisch ist. Er stellt in dem Falle, in dem der zu prüfende Halbleiterspeicher in Ordnung ist (Gut-Fall), die aus den Zellenfeldern ZF ausgelesene Information zur Verfügung ("0" oder "1"). Dabei kann sogar eine Messung der Speicherzugriffszeit durchgeführt werden. Um die Information zur Verfügung stellen zu können, ist es notwendig, den Ausgang der zweiten Kippschaltung FF2 über ihren Seteingang S auf log. "1" zu setzen. Dies erfolgt mittels der Setschaltung SS, die nachfolgend noch beschrieben wird. Im Fehlerfall jedoch wird der Ausgang der zweiten Kippschaltung FF2 auf log. "0" rückgesetzt, der Ausgang $AUS_{Test}$ der Auswertschaltung AS, und damit der des vierten UND-Gatters G4 ist unabhängig von den (im GUT-Fall) erwarteten Daten auf log. "0" (Fehlersignal). Wie bereits beschrieben, ist damit jedoch das Fehlersignal nicht von einer eventuell als log. "0" erwarteten, aus dem Speicher auszulesenden Information zu unterscheiden.

Die Setschaltung SS, die ja mit ihrem Ausgang den Seteingang S der zweiten Kippschaltung FF2 bildet, hat nun zwei (Teil-)Aufgaben:

a) Sie muß nach dem Auftreten eines Fehlers den Ausgang der zweiten Kippschaltung FF2, und damit den über den entsprechenden Eingang des vierten UND-Gatters G4 an Ausgang der Auswertschaltung AS das Fehlersignal aktiv (= log. '0') halten. Damit ist es möglich, einen beim Auslesen von log. "0" aus den Zellenfeldern ZF aufgetretenen Fehler, der ja am Ausgang der Auswertschaltung AS nicht erkennbar ist (siehe oben), solange zu "speichern", bis erstmals aus den Zellenfeldern ZF (fehlerhaft oder richtig, kein Unterschied in der Auswertung) eine log. "1" ausgelesen werden soll. Jetzt nämlich unterscheidet sich auf jeden Fall die am Ausgang des vierten UND-Gatters G4 erwartete Information log. "1" vom aktivierten Fehlersignal ("0").

b) Sie muß beim Einschalten des Testbetriebes oder der Betriebsspannung sicherstellen, daß der Ausgang der zweiten Kippschaltung FF2 keinesfalls bereits einen Fehler vortäuscht, d.h. er muß auf log. "1" gesetzt werden. Dies geschieht beispielsweise durch ein übliches Differenzierglied DG, das vom Steuersignal P angestoßen, einen Impuls abgibt, den ein erster Eingang eines ODER-Gatters G5 als log. "1" interpretiert und damit über seinen Ausgang, der sowohl einen Ausgang der Setschaltung SS als auch den Seteingang S der zweiten Kippschaltung FF2 bildet, den Ausgang der zweiten Kippschaltung FF2 auf log. "1" setzt.

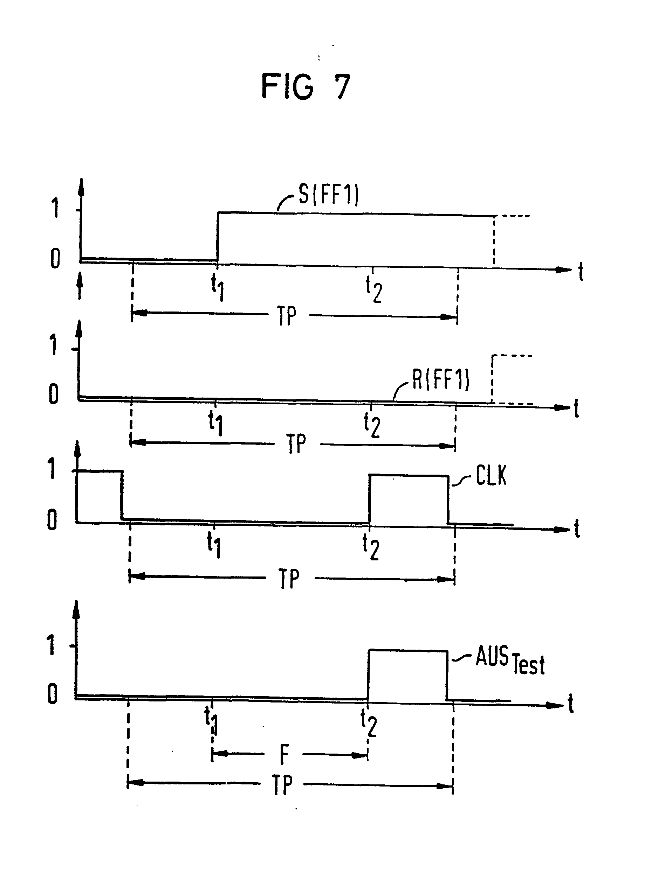

Die mit a) angesprochene Bedingung, die an die Setschaltung SS gestellt ist, wird durch folgende (Teil-)Schaltung erfüllt: Der Ausgang des ersten UND-Gatters G1, der ja sowohl als Seteingang S auf die erste Kippschaltung FF1 als auch als erster Eingang des dritten UND-Gatters G3 wirkt, ist noch als ein Eingang auf ein weiteres UND-Gatter G6 geschaltet. Ein zweiter Eingang dieses UND-Gatters G6 ist mit einem Maschinentakt CLK verknüpft. Bei Abgabe eines positiven Impulses dieses Maschinentaktes CLK wird also der erste Eingang dieses UND-Gatters G6 auf seinen Ausgang durchgeschaltet, der wiederum als zweiter Eingang des ODER-Gatters G5 wirkt, und damit als Seteingang S für die zweite Kippschaltung FF2. Legt man nun innerhalb einer Taktperiode TP, mit der der Halbleiterspeicher betrieben wird, an einen geeigneten, in Fig. 7 gezeigten Zeitpunkt $t_2$, das Auftreten des Maschinentaktes CLK, so kann man einerseits ein Deaktivieren des Fehlersignales, das aufgrund eines in früheren Taktperioden TP aufgetretenen Fehlers aktiviert worden war, von einem Zeitpunkt $t_1$, zu dem

eine log. "1" durch das erste UND-Gatter G1 erkannt wird, bis zu einem Zeitpunkt $t_2$ verzögern, d.h. ein Prüfautomat kann z. B. zwischen den beiden Zeitpunkten $t_1$ und $t_2$ aufgetretene Fehler F erkennen. Andererseits wird nach dem Zeitpunkt $t_2$ letztendlich der Ausgang des ersten UND-Gatters G1 auf den Seteingang S der zweiten Kippstufe durchgeschaltet, falls dieser Ausgang auf log. "1" ist. Damit wird aber der Ausgang der zweiten Kippschaltung FF2 auf log. "1" gesetzt, was einem Deaktivieren und Rücksetzen des Fehlersignales entspricht.

Die Ausführungsform der Erfindung nach Fig. 1 weist auf vorteilhafte Weise noch je Bit der Breite m der Datenschnittstellen eine vierte Datenweiche DW4 auf, die dazu dient, auf den Datenausgangsanschluß $D_0$ im Normalbetrieb die aus der jeweiligen zweiten Datenweiche DW2 austretenden Informationen $AUS_{Norm}$ auf den jeweiligen Datenausgangsanschluß $D_0$ zu schalten und im Testbetrieb statt dessen den Ausgang $AUS_{Test}$ der jeweiligen Auswerteschaltung AS mit dem entsprechenden DO-Anschluß $D_0$ zu verbinden. Diesem Zwecke dienen je vierter Datenweiche DW4 zwei Transistoren. Deren Drain-Anschlüsse sind gemeinsam mit dem zugehörigen Datenausgangsanschluß $D_0$ verbunden. Der Sourceanschluß des einen Transistors ist mit dem Ausgang der zweiten Datenweiche DW2 verbunden, während der Sourceanschluß des anderen Transistors mit dem Ausgang der Auswerteschaltung AS verbunden ist. Der eine Transistor wird gatemäßig von einem zum Steuersignal P komplementären Signal P angesteuert; der andere vom Steuersignal P. Damit ist es möglich, wahlweise den Ausgang der zweiten Datenweiche DW2 oder den der Auswerteschaltung AS auf den Datenausgangsanschluß $D_0$ zu schalten.

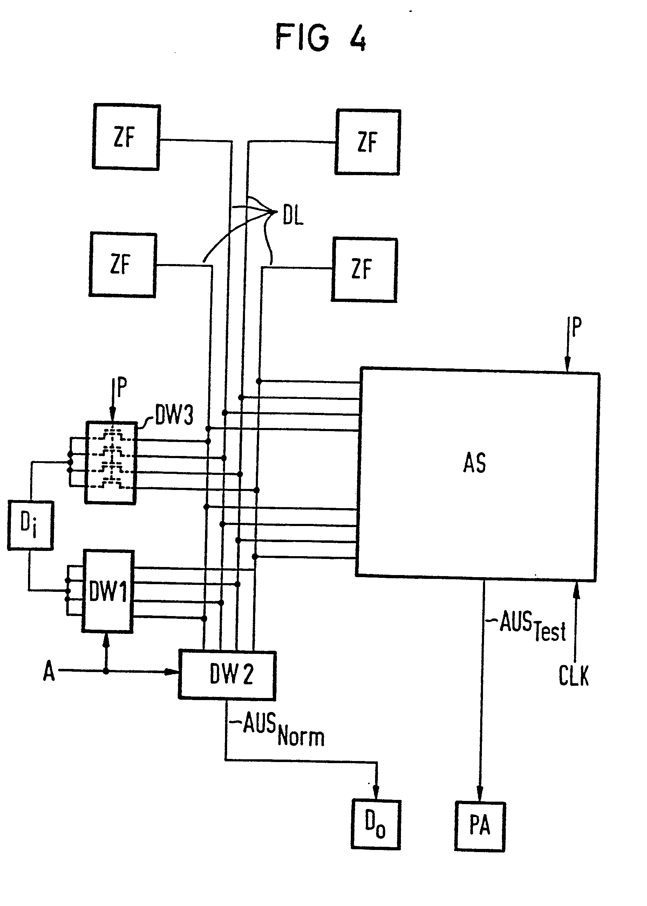

Es ist jedoch in einer anderen Ausführungsform durchaus auch möglich, den Ausgang jeder der zweiten Datenweichen DW2 direkt auf den zugehörigen Datenausgangsanschluß $D_0$ zu schalten und den Ausgang jeder Auswerteschaltung AS, ebenfalls direkt, separat auf einen eigenen Anschluß PA im Sinne eines Prüfanschlusses zu legen. Diese Ausführungsform ist in Fig. 4 gezeigt.

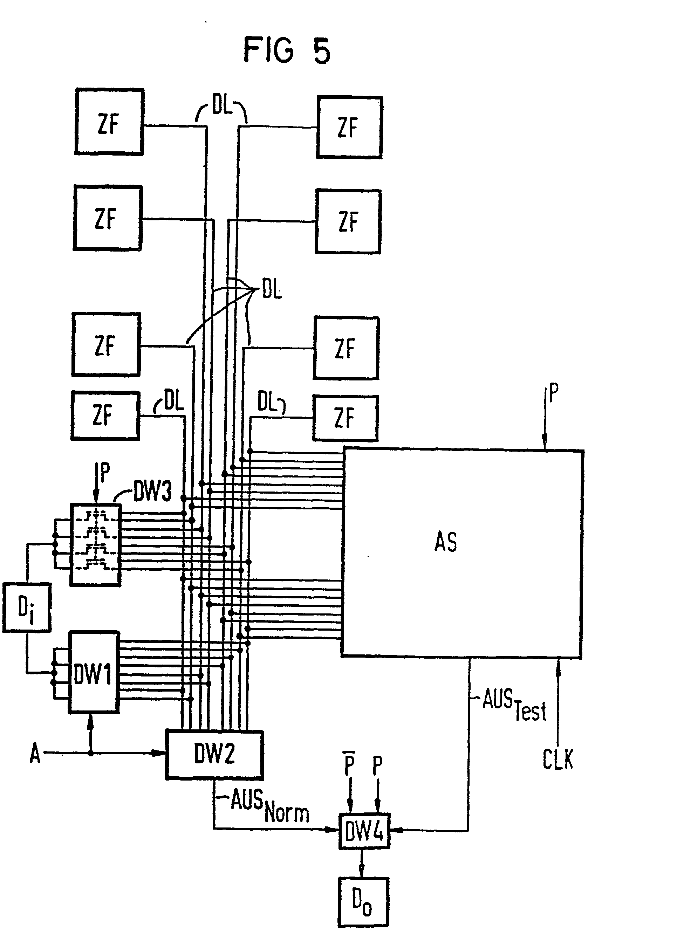

Fig. 5 zeigt eine Ausführungsform eines erfindungsgemäßen Halbleiterspeichers, bei dem anstelle von n = 4 Zellenfelder ZF n = 8 Zellenfelder ZF verwendet werden. Die Funktion des Halbleiterspeichers ist dieselbe wie für Fig. 1 beschrieben. Es tritt jedoch im Testbetrieb eine noch stärkere Reduzierung der Testzeit ein.

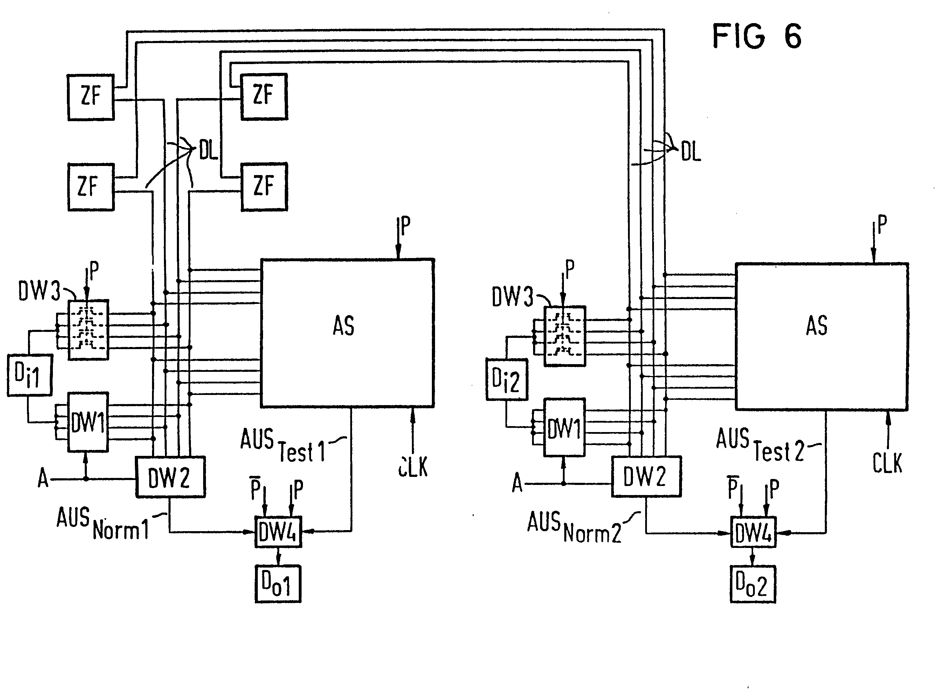

Fig. 6 zeigt eine Ausführungsform eines erfindungsgemäßen Halbleiterspeichers, bei dem wiederum n = 4 Zellenfelder ZF verwendet sind, der jedoch eine Breite von m = 2 Bit bei den Datenschnittstellen besitzt. Die Funktion ist dieselbe, wie in Fig. 1 beschrieben. Es ist lediglich klarzustellen, daß jeweils beide dargestellte erste Datenweichen DW1, zweite Datenweichen DW2, dritte Datenweichen DW3 und vierte Datenweichen DW4, die Zellenfelder ZF sowie die beiden Auswerteschaltungen AS jeweils zueinander parallel und unabhängig voneinander arbeiten. Zur Verdeutlichung der Tatsache, daß die Datenschnittstellen der m = 2 Bits voneinander unabhängige Informationen führen, wurden an Stelle der Bezeichnungen $D_i$, $D_o$, $AUS_{Test}$, $AUS_{Norm}$, die Bezeichnungen $D_{I1}$, $D_{o1}$, $D_{I2}$, $D_{o2}$, $AUS_{Test1}$, $AUS_{Test2}$, $AUS_{Norm1}$ und $AUS_{Norm2}$ gewählt.

Weitere, verschiedene Ausgestaltungen der vorliegenden Erfindung sind möglich, insbesondere auch bei der Ausgestaltung der Auswerteschaltung AS. Sie liegen jedoch allesamt im Bereiche dieser Erfindung, denn es stellt für den Durchschnittsfachmann kein Problem dar, die aufgezeigten Logikschaltungen abzuändern, ohne dabei die der Erfindung zugrundeliegende Aufgabenstellung oder den Grundgedanken der Erfindung zu verlassen.

**Patentansprüche**

1. Integrierter Halbleiterspeicher mit n einander gleichen Speicherzellenfeldern (ZF), mit n · m Datenleitungen (DL) zum Einschreiben und Auslesen von Speicherdaten in die bzw. aus den Speicherzellenfeldern (ZF), mit m ersten Datenweichen (DW1), von denen jede beim Einschreiben an einem ihr zugeordneten Dateneingangsanschluß ($D_i$) anliegende, in den Halbleiterspeicher einzuschreibende Speicherdaten in Abhängigkeit von Adressierungsdaten an jeweils eine der n ihr zugehörigen Datenleitungen (DL) anlegt, mit m zweiten Datenweichen (DW2), von denen jede beim Auslesen von Speicherdaten, die auf jeweils n Datenleitungen (DL) anliegen, in Abhängigkeit von Adressierungsdaten eine der n Datenleitungen (DL) auswählt und über einen Ausgang an einen zugehörigen Datenausgangsanschluß ($D_o$) anlegt, *dadurch gekennzeichnet*, daß an jeweils n der n · m Datenleitungen (DL), parallel zu der jeweiligen zweiten Datenweiche (DW2) eine Auswerteschaltung (AS) angeschlossen ist, die als Ausgangssignal ($AUS_{Test}$) in Abhängigkeit von einem Steuersignal (P) einerseits die aus den Speicherzellenfeldern (ZF) ausgelesenen Speicherdaten zu dem entsprechenden Datenausgangsanschluß ($D_o$) durchschaltet, und andererseits, im Falle des Auftretens von mindestens einem fehlerhaften Speicherdatum, an den entsprechenden Datenausgangsanschluß ($D_o$) eine Fehlerinformation gibt, daß zwischen jedem der m Dateneingangsanschlüsse ($D_i$) und den zugehörigen n von n · m Datenleitungen (DL), parallel zur jeweiligen ersten Datenweiche (DW1), eine dritte Datenweiche (DW3) geschaltet ist, die in Abhängigkeit vom Steuersignal (P) die in den Halbleiterspeicher einzuschreibenden Speicherdaten parallel an alle n Datenleitungen (DL) übergibt, daß jedem der m Datenausgangsanschlüsse ($D_o$) eine vierte Datenweiche (DW4) vorgeschaltet ist, die in Abhängigkeit vom Steuersignal (P) und einem zu diesem komplementären Signal ($\overline{P}$) entweder das von der zweiten Datenweiche (DW2) ausgewählte Speicherdatum ($AUS_{Norm}$) oder das von der Auswerteschaltung (AS) erzeugte Ausgangssignal ($AUS_{Test}$) an den Datenausgangsanschluß ($D_o$) durchschaltet, und daß für das Steuersignal (P) ein weiterer Anschluß ($A_X$; T) vorgesehen ist.

2. Integrierter Halbleiterspeicher nach Anspruch 1, *dadurch gekennzeichnet*, daß jede Auswerteschaltung (AS) zum Durchschalten der aus den Speicherzellenfeldern (ZF) ausgelesenen Speicherdaten eine erste Kippschaltung (FF1) mit zwei Eingängen und einem Ausgang enthält, deren erster Eingang (Seteingang S) aktiviert wird, wenn alle an die Auswerteschaltung (AS) angeschlossenen n Datenleitungen (DL) einen ersten logischen Zustand aufweisen (Gut-Fall), und deren zweiter Eingang (Reseteingang, R) aktiviert wird, wenn alle an die Auswerteschaltung (AS) angeschlossenen n Datenleitungen (DL) einen zum ersten logischen Zustand komplementären zweiten logischen Zustand aufweisen (Gut-Fall), so daß in dem Falle, in dem alle besagten n Datenleitungen (DL) denselben (ersten oder zweiten) logischen Zustand besitzen, der Ausgang der ersten Kippschaltung (FF1) gezielt gesetzt bzw. rückgesetzt wird, daß für den Fall (Fehlerfall), in dem alle an die Auswerteschaltung (AS) angeschlossenen n Datenleitungen (DL) gemeinsam weder den ersten noch den zweiten logischen Zustand besitzen, eine zweite Kippschaltung (FF2) vorgesehen ist mit zwei Eingängen und einem Ausgang, deren einer Eingang (Reseteingang, R) im Fehlerfalle den Ausgang der zweiten Kippschaltung (FF2) zurücksetzt, deren anderer Eingang (Seteingang, S) zum Setzen des Ausgangs der zweiten Kippschaltung (FF2) über den Ausgang einer Setschaltung (SS) angesteuert wird.

3. Integrierter Halbleiterspeicher nach Anspruch 2, *dadurch gekennzeichnet*, daß der Ausgang der Setschaltung (SS) aktiviert wird zum einen bei einem Aktivieren des Steuersignales (P) oder beim Anlegen einer Betriebsspannung an den Halbleiterspeicher durch ein Differenzierglied (DG), und zum anderen mittels eines Ausganges einer UND-Funktion (G6) mit zwei Eingängen, deren erster Eingang mit dem Seteingang (S) der ersten Kippschaltung (FF1) verbunden ist und deren zweiter Eingang an einen Maschinentakt (CLK) angeschlossen ist.

4. Integrierter Halbleiterspeicher nach Anspruch 2 oder 3, *dadurch gekennzeichnet*, daß der Maschinentakt (CLK) den Seteingang (S) der zweiten Kippschaltung (FF2) innerhalb einer Taktperiode (TP), solange verzögert, bis eine am entsprechenden Datenausgangsanschluß ($D_o$) angeschlossene Prüfschaltung das, gegebenenfalls während einer früheren Taktperiode aktivierte, Fehlersignal als solches erkennen konnte (Fig. 7).

5. Integrierter Halbleiterspeicher nach einem der Ansprüche 2 bis 4, *dadurch gekennzeichnet, daß* das Ausgangssignal jeder Auswerteschaltung (AS) in einer weiteren logischen Funktion (G4) erzeugt wird, die als Eingänge die Ausgänge der ersten und zweiten Kippschaltung (FF1, FF2) aufweist.

6. Integrierter Halbleiterspeicher nach einem der vorhergehenden Ansprüche, *dadurch gekennzeichnet, daß* jede der dritten Datenweichen (DW3) n Transistoren enthält, die mit ihrer Durchlaßstrecke einerseits alle an den zugehörigen Dateneingangsanschluß ($D_i$) und andererseits an je eine der n zu dem jeweiligen Dateneingangsanschluß ($D_i$) gehörigen Datenleitung (DL) angeschlossen sind, und deren Gates parallel an das Steuersignal (P) angeschlossen sind.

7. Integrierter Halbleiterspeicher nach einem der vorhergehenden Ansprüche, *dadurch gekennzeichnet, daß* jede der m vierten Datenweichen (DW4) zwei Transistoren enthält, daß die Drainanschlüsse der beiden Transistoren zusammengeschaltet sind und mit dem der jeweiligen vierten Datenweiche (DW4) zugehörigen Datenausgangsanschluß ($D_o$) verbunden sind, daß bei jeder der vierten Datenweichen (DW4) der eine Transistor mit seinem Sourceanschluß mit dem Ausgang der zugehörigen zweiten Datenweiche (DW2) verbunden ist, daß bei jeder der vierten Datenweichen (DW4) der andere Transistor mit seinem Sourceanschluß mit dem Ausgang der zugehörigen Auswerteschaltung (AS) verbunden ist, daß das Gate des einen Transistors mit einem zum Steuersignal (P) komplementären Signal ($\overline{P}$) verbunden ist, und daß das Gate des anderen Transistors mit dem Steuersignal (P) verbunden ist.

8. Integrierter Halbleiterspeicher nach einem der vorhergehenden Ansprüche, *dadurch gekennzeichnet, daß* der weitere Anschluß für das Steuersignal (P) ein eigener, sonst unbenutzter Anschluß (T) des Halbleiterspeichers ist.

9. Integrierter Halbleiterspeicher nach einem der vorhergehenden Ansprüche, *dadurch gekennzeichnet, daß* der weitere Anschluß für das Steuersignal (P) ein Anschluß ($A_x$) ist, der auch für sonstige Signale vom Halbleiterspeicher benutzt wird.

10. Integrierter Halbleiterspeicher nach Anspruch 9, *dadurch gekennzeichnet, daß* der weitere Anschluß ($A_x$) ein Anschluß ist, an den bei einem Normalbetrieb ein Adreßsignal angelegt wird, das das höchstwertige der Adreßsignale ist.

11. Integrierter Halbleiterspeicher nach Anspruch 9 oder 10, *dadurch gekennzeichnet, daß* zum Umschalten vom Normalbetrieb auf einen Testbetrieb, bei dem die Auswerteschaltungen (AS) benützt werden, ein größeres Potential angelegt wird, als das, das dem Anlegen einer log. "1" entspricht.

12. Integrierter Halbleiterspeicher nach Anspruch 11, *dadurch gekennzeichnet, daß* das Steuersignal (P) mittels einer Diskriminatorschaltung (DS) aktiviert wird, die erkennt, ob das größere Potential anliegt.

13. Integrierter Halbleiterspeicher nach einem der vorhergehenden Ansprüche, *dadurch gekennzeichnet, daß* der Ausgang jeder der m zweiten Datenweichen (DW2) direkt auf den jeweils zugehörigen Datenausgangsanschluß ($D_o$) geführt ist, während der Ausgang jeder der zugehörigen m Auswerteschaltungen (A3) auf einen eigenen, sonst unbenutzten Anschluß (PA) geführt ist.

**Claims**

1. Integrated semiconductor memory having n memory cell arrays (ZF) which are identical to one another, having n · m data lines (DL) for reading memory data into the memory cell arrays (ZF) or reading them out therefrom respectively, having m first data selectors (DW1), of which each applies, when writing in memory data, which is present at a data input connection ($D_i$) associated with it and which has to be written into the semiconductor memory, to one of the n data lines (DL) associated with it in each case as a function of addressing data, having m second data selectors (DW2), of which each selects, when reading out memory data which are present on n data lines (DL) in each case, one of the n data lines (DL) as a function of addressing data and applies it to an associated data output connection ($D_o$) via an output, characterized in that an evaluation circuit (AS) is connected in each case to n of the n · m data lines (DL) in parallel with the respective second data selector (DW2), which evaluation circuit connects, as a function of a control signal (P), on the one hand the memory data read out from the memory cell arrays (ZF) as output signal ($AUS_{Test}$) to the corresponding data output connection ($D_o$) and on the other hand, supplies an error signal to the corresponding data output connection ($D_o$) in the event of the occurrence of at least one incorrect memory datum, in that between each of the m data input connections ($D_i$) and the associated n of n · m data lines (DL), there is connected in parallel with the respective first data selector (DW1) a third data selector (DW3) which transfers the memory data to be written into the semiconductor memory in parallel to all the n data lines (DL) as a function of the control signal (P), in that a fourth data selector (DW4) is connected upstream of each of the m data output connections ($D_o$), which data selector connects, as a function of the control signal (P) and a signal ($\overline{P}$) complementary to the latter, either the memory datum ($AUS_{Norm}$) selected by the second data selector (DW2) or the output signal ($AUS_{Test}$) produced by the evaluation circuit (AS) to the data output connection ($D_o$),

and in that a further connection (A$_X$; T) is provided for the control signal (P).

2. Integrated semiconductor memory according to Claim 1, characterized in that each evaluation circuit (AS) comprises, for connecting the memory data read out of the memory cell arrays (ZF), a first flipflop (FF1) having two inputs and one output whose first input (set input S) is activated if all the n data lines (DL) connected to the evaluation circuit (AS) exhibit a first logic state ("good" case) and whose second input (reset input R) is activated if all the n data lines (DL) connected to the evaluation circuit (AS) exhibit a second logic state ("good" case) complementary to the first logic state so that the output of the first flipflop (FF1) is systematically set or reset respectively in the case where all the said n data lines (DL) have the same (first or second) logic state, and in that, for the case (error case) in which all the n data lines (DL) connected to the evaluation circuit (AS) jointly do not have either the first or the second logic state, a second flipflop (FF2) is provided which has two inputs and one output, one input of which (reset input, R) resets the output of the second flipflop (FF2) in the error case and the other input of which (set input, S) is triggered to set the output of the second flipflop (FF2) via the output of a set circuit (SS).

3. Integrated semiconductor memory according to Claim 2, characterized in that the output of the set circuit (SS) is activated, on the one hand, if the control signal (P) is activated or if an operating voltage is applied to the semiconductor memory by a differentiating element (DG) and, on the other hand, by means of an output of a AND function (G6) having two inputs whose first input is connected to the set input (S) of the first flipflop (FF1) and whose second input is connected to a machine clock (CLK).

4. Integrated semiconductor memory according to Claim 2 or 3, characterized in that the machine clock (CLK) delays the set input (S) of the second flipflop (FF2) within one clock cycle (TP) until a test circuit connected to the corresponding data output connection (D$_o$) has been able to recognise the error signal, possibly activated during an earlier clock cycle, as such (Figure 7).

5. Integrated semiconductor memory according to one of claims 2 to 4, characterized in that the output signal of each evaluation circuit (AS) is produced in a further logic function (G4) which has the outputs of the first and second flipflop (FF1, FF2) as inputs.

6. Integrated semiconductor memory according to one of the preceding claims, characterized in that each of the third data selectors (DW3) comprises n transistors which are all connected by means of their conduction path, on the one hand, to the associated data input connection (D$_i$) and, on the other hand, to one of the n data line (sic) (DL) associated with the respective data input connection (D$_i$) and whose gates are connected in parallel to the control signal (P).

7. Integrated semiconductor memory according to one of the preceding claims, characterized in that each of the m fourth data selectors (DW4) comprises two transistors, in that the drain connections of the two transistors are connected together and are connected to the data output connection (D$_o$) associated with the respective fourth data selector (DW4), in that, in each of the fourth data selectors (DW4) one transistor is connected by means of its source connection to the output of the associated second data selector (DW2), in that, in each of the fourth data selectors (DW4) the other transistor is connected by means of its source connection to the output of the associated evaluation circuit (AS), in that the gate of one transistor is connected to a signal (P) complementary to the control signal (P), and in that the gate of the other transistor is connected to the control signal (P).

8. Integrated semiconductor memory according to one of the preceding claims, characterized in that the further connection for the control signal (P) is a special, otherwise unused connection (T) of the semiconductor memory.

9. Integrated semiconductor memory according to one of the preceding claims, characterized in that the further connection for the control signal (P) is a connection (A$_x$) which is also used for other signals of the semiconductor memory.

10. Integrated semiconductor memory according to Claim 9, characterized in that the further connection (A$_x$) is a connection to which there is applied, during normal operation, an address signal which is the most significant of the address signals.

11. Integrated semiconductor memory according to Claim 9 or 10, characterized in that, to switch from the normal mode to a test mode in which the evaluation circuits (AS) are used, a higher potential is applied than that which corresponds to applying a logical "1".

12. Integrated semiconductor memory according to Claim 11, characterized in that the control signal (P) is activated by means of a discriminator circuit (DS) which detects whether the higher potential is present.

13. Integrated semiconductor memory according to one of the preceding claims, characterized in that the output of each of the m second data selectors (DW2) is fed directly to the data output connection (D$_o$) associated in each case while the output of each of the associated m evaluation circuits (AS) is fed to a special, otherwise unused connection (PA).

## Revendications

1. Mémoire intégrée à semiconducteurs comportant n zones identiques (ZF) de cellules de mémoire, comportant n · m lignes (DL) de transmission de données permettant l'enregistrement de données de mémoire dans les zones (ZF) de cellules de mémoire et la lecture de données de mémoire hors de ces zones, m premiers aiguillages de transmission de données (DW1), dont chacun applique des données de mémoire, qui sont présentes, lors de l'enregistrement, au niveau d'une borne ($D_i$) d'entrée des données, qui leur est associée, et doivent être enregistrées dans la mémoire à semiconducteurs, à l'une des n lignes (DL) de transmission de données, qui leur sont associées, en fonction de données d'adressage, m seconds aiguillages (DW2) de transmission de données, dont chacun sélectionne l'une des n lignes (DL) de transmission de données, lors de la lecture de données de mémoire, qui sont présentes dans n lignes respectives (DL) de transmission de données, en fonction de données d'adressage et applique ces données, par l'intermédiaire d'une sortie, à une borne associée ($D_o$) de sortie des données, caractérisée par le fait qu'à respectivement n des n · m lignes (DL) de transmission de données est raccordé, en parallèle avec le second aiguillage respectif (DW2) de transmission de données, un circuit d'évaluation (AS), qui transmet directement, en tant que signal de sortie ($AUS_{essai}$), en fonction d'un signal de commande (P), d'une part les données de mémoire lues à partir des zones (ZF) de cellules de la mémoire en direction de la borne correspondante ($D_o$) de sortie des données, et d'autre part, dans le cas de l'apparition d'au moins une donnée défectueuse de mémoire, une information d'erreur à la borne correspondante ($D_o$) de sortie des données, qu'entre chacune des m bornes ($D_i$) d'entrée des données et les n lignes associées faisant partie de n · m lignes (DL) de transmission de données est branché, en parallèle avec le premier aiguillage respectif (DW1) de transmission de données, un troisième aiguillage (DW3) de transmission de données, qui, en fonction du signal de commande (P), retransmet en parallèle les données de mémoire, devant être enregistrées dans la mémoire de données, à l'ensemble des n lignes (DL) de transmission de données, qu'en amont de chacune des m bornes ($D_o$) de sortie des données se trouve branché un quatrième aiguillage (DW4) de transmission de données, qui, en fonction du signal de commande (P) et d'un signal (P) complémentaire du précédent, transmet directement soit la donnée de mémoire ($AUS_{norme}$) sélectionnée par le second aiguillage (DW2) de transmission de données, soit le signal de sortie ($AUS_{essai}$), produit par le circuit d'évaluation (AS), à la borne ($D_o$) de sortie des données, et qu'une autre borne ($A_x$; T) est prévue pour le signal de commande P.

2. Mémoire intégrée à semiconducteurs suivant la revendication 1, caractérisée par le fait que chaque circuit d'évaluation (AS) contient, pour la transmission directe des données de mémoire lues à partir des zones (ZF) de cellules de mémoire, un premier circuit à bascule (FF1), qui comporte deux entrées et une sortie et dont la première entrée (entrée de positionnement S) est activée lorsque la totalité des n lignes (DL) de transmission de données, raccordées au circuit d'évaluation (AS), possèdent un premier état logique (cas bon) et dont la seconde entrée (entrée de remise à l'état initial R) est activée lorsque la totalité des n lignes (DL) de transmission de données, raccordées au circuit d'évaluation (AS), possède un second état logique complémentaire du premier état logique (cas bon) de sorte que, dans le cas où l'ensemble desdites n lignes (DL) de transmission de données possèdent le même (premier ou second) état logique, la sortie du premier circuit à bascule (FF1) est volontairement positionnée ou ramenée à l'état initial, que dans le cas (cas d'erreur), où la totalité des n lignes (DL) de transmission de données, raccordées au circuit d'évaluation (AS), ne possède en commun ni le premier état logique, ni le second état logique, il est prévu un second circuit à bascule (FF2), qui comporte deux entrées et une sortie et dont une entrée (entrée de remise à l'état initial R) ramène à l'état initial la sortie du second circuit à bascule (FF2), dans le cas d'une erreur, et dont l'autre entrée (entrée de positionnement S) est commandée de manière à positionner la sortie du second circuit à bascule (FF2) par l'intermédiaire de la sortie d'un circuit de positionnement (SS).

3. Mémoire intégrée à semiconducteurs suivant la revendication 2, caractérisée par le fait que la sortie du circuit de positionnement (SS) est activée d'une part, lors d'une activation du signal de commande (P) ou lors de l'application d'une tension de service à la mémoire à semiconducteurs, par l'intermédiaire d'un circuit différentiateur (DG), et d'autre part au moyen d'une sortie d'une porte ET (G6) comportant deux entrées, dont la première entrée est reliée à l'entrée de positionnement (S) du premier circuit à bascule (FF1) et dont la seconde entrée reçoit une cadence machine (CLK).

4. Mémoire intégrée à semiconducteurs suivant la revendication 2 ou 3, caractérisée par le fait que la cadence machine (CLK) retarde l'entrée de positionnement (S) du second circuit à bascule (FF2), au cours d'une période (TP) de la cadence, jusqu'à ce qu'un circuit de contrôle, raccordé à la borne correspondante ($D_o$) de sortie des données, ait pu identifier en tant que tel le signal d'erreur éventuellement déclenché pendant une période antérieure de la cadence (figure 7).

5. Mémoire intégrée à semiconducteurs suivant l'une des revendications 2 à 4, caractérisée par le fait que le signal de sortie de chaque circuit d'évaluation (AS) est produit dans une seconde porte logique (G4), dont les entrées sont constituées par les sorties des premier et second circuits à bascule (FF1, FF2).

6. Mémoire intégrée à semiconducteurs suivant l'une des revendications précédentes, caractérisée par le fait que chacun des troisièmes aiguillages (DW3) de transmission de données contient n transistors, qui sont tous raccordés, par leur section de transmission à l'état passant, d'une part à la borne associée (D$_i$) d'entrée des données et d'autre part à une ligne respective faisant partie des n lignes (DL) de transmission de données, associées à la borne respective (D$_i$') d'entrée des données, et dont les grilles reçoivent en parallèle le signal de commande (P).

7. Mémoire intégrée à semiconducteurs suivant l'une des revendications précédentes, caractérisée par le fait que chacun des m quatrièmes aiguillages (DW4) de transmission de données contient deux transistors, que les bornes de drain des deux transistors sont interconnectées et sont reliées à la borne (D$_o$) de sortie des données, associée au quatrième aiguillage respectif (DW4) de transmission de données, que, dans chacun des quatrièmes aiguillages (DW4) de transmission de données, la borne de source d'un transistor est raccordée à la sortie du second aiguillage associé (DW2) de transmission de données, que dans chacun des quatrièmes aiguillages (DW4) de transmission de données, la borne de source de l'autre transistor est raccordée à la sortie du circuit d'évaluation associé (AS), que la grille d'un transistor reçoit un signal (P) complémentaire du signal de commande (P) et que la grille de l'autre transistor reçoit un signal de commande (P).

8. Mémoire intégrée à semiconducteurs suivant l'une des revendications précédentes, caractérisée par le fait que l'autre borne pour le signal de commande (P) est une borne particulière (A), non utilisée par ailleurs, de la mémoire à semiconducteurs.

9. Mémoire intégrée à semiconducteurs suivant l'une des revendications précédentes, caractérisée par le fait que l'autre borne pour le signal (P) est une borne (A$_x$), qui est également utilisée pour d'autres signaux de la mémoire à semiconducteurs.

10. Mémoire intégrée à semiconducteurs suivant la revendication 9, caractérisée par le fait que l'autre borne (A$_x$) est une borne, à laquelle est appliquée, lors d'un fonctionnement normal, un signal d'adresse qui est celui des signaux d'adresses, qui possède le poids maximum.

11. Mémoire intégrée à semiconducteurs suivant la revendication 9 ou 10, caractérisée par le fait que pour le passage du fonctionnement normal à un fonctionnement d'essai, lors duquel les circuits d'évaluation (AS) sont utilisés, un potentiel supérieur à celui qui correspond à l'application d'un "1" logique, est appliqué.

12. Mémoire intégrée à semiconducteurs suivant la revendication 11, caractérisée par le fait que le signal de commande (P) est activé au moyen d'un circuit discriminateur (DS), qui identifie si le potentiel supérieur est présent.

13. Mémoire intégrée à semiconducteurs suivant l'une des revendications précédentes, caractérisée par le fait que la sortie de chacun des m seconds aiguillages (DW2) de transmission de données est raccordée directement à la borne respectivement associée (D$_o$) de sortie des données, tandis que la sortie de chacun des m circuits associés d'évaluation (AS) est raccordée à une borne particulière (PA) par ailleurs non utilisée.

# FIG 1

# FIG 2

# FIG 3

# FIG 4

# FIG 5

FIG 6

EP 0 186 040 B1

# FIG 7